# EUROPÄISCHE PATENTANMELDUNG

(11) **EP 1 406 090 A1**
(43) Veröffentlichungstag der Anmeldung: **07.04.2004**
(21) Anmeldenummer: 03022285.5
(22) Anmeldetag: 01.10.2003
(51) Int. Cl.: G01N 33/543, G01N 21/77

(54) **Optoelektronischer Sensor insbesondere zur Detektion von makromolekularen Biopolymeren**

(30) Priorität: 02.10.2002 DE 10246026; 28.11.2002 DE 10255599
(71) Anmelder: Infineon Technologies AG, 81669 München (DE)
(72) Erfinder: Dertinger, Stephan, 80335 München (DE); Fritz, Michaela, 81673 München (DE); Haneder, Thomas, 85221 Dachau (DE); Hanke, Hans-Christian, 81479 München (DE); Hofmann, Franz, 80995 München (DE); Lehmann, Volker, 80689 München (DE); Luyken, Richard Johannes, 81825 München (DE); Martin, Alfred, 81825 München (DE)
(74) Vertreter: Müller-Boré & Partner Patentanwälte

(57) **Zusammenfassung**

Die vorliegende Erfindung betrifft eine Vorrichtung mit einem flächig ausgebildetem Trägermaterial (10), welches über zumindest einen Oberflächenbereich verteilt eine Vielzahl von Poren (11) aufweist, welche sich von einer Oberfläche (12) des Trägermaterials zu der gegenüberliegenden Oberfläche (13) durchgängig erstrecken, wobei
- die Poren jeweils durch eine Porenbegrenzungsfläche (14) der in dem Trägermaterial ausgebildeten Porenwände (15) begrenzt sind,
- zumindest ein Teil der Porenwände mindestens bereichsweise einen Schichtaufbau mit einem ersten dotierten Halbleiterbereich (20) und einem von der Porenbegrenzungsfläche beabstandeten zweiten, komplementär dotierten Halbleiterbereich (30) unter Bildung eines p-noder eines p-i-n-Übergangs aufweist, und
- der erste (20) und der zweite (30) Halbleiterbereich jeweils getrennt voneinander mit einem Anschlußkontakt zur Verschaltung des p-n- bzw. des p-i-n-Übergangs als Photodiode versehen sind.
Die erfindungsgemäße Vorrichtung eignet sich als optoelektronischer Biosensor in Verfahren zum Nachweis biochemischer Reaktionen und/oder Bindungen sowie hierfür insbesondere zur Untersuchung von enzymatischen Reaktionen, Nukleinsäure-Hybridisierungen, Protein-Protein-Wechselwirkungen und Protein-Liganden-Wechselwirkungen.

## Beschreibung

Die vorliegende Erfindung betrifft eine Vorrichtung auf Basis eines makroporösen, flächig ausgebildeten Trägermaterials, wobei innerhalb des mit Poren strukturierten Trägermaterials entlang der Porenlängsachsen an bzw. in den Porenwänden ein p-n- oder ein p-i-n-Übergang mit getrennt ankontaktierbaren p- und n-Bereichen angeordnet ist. Die erfindungsgemäße Vorrichtung eignet sich insbesondere als optoelektronischer Biosensor in Verfahren zum Nachweis biochemischer Reaktionen und/oder Bindungen sowie hierfür insbesondere zur Untersuchung von enzymatischen Reaktionen, Nukleinsäure-Hybridisierungen, Protein-Protein-Wechselwirkungen und Protein-Liganden-Wechselwirkungen.

In der Molekularbiologie finden heute in zunehmendem Maße Biochips Verwendung, mit denen auf schnelle Art und Weise Erkenntnisse über Organismen und Gewebe gewonnen werden. Für die Biowissenschaften und die medizinische Diagnostik ist die Detektion (bio)chemischer Reaktionen, d.h. die Detektion biologisch relevanter Moleküle in definiertem Untersuchungsmaterial von herausragender Bedeutung. In diesem Rahmen wird die Entwicklung von sogenannten BioChips bzw. Biosensoren stetig vorangetrieben. Bei derartigen BioChips handelt es sich üblicherweise um miniaturisierte hybride Funktionselemente mit biologischen und technischen Komponenten, insbesondere auf einer Oberfläche eines BioChip-Grundmoduls immobilisierten Biomolekülen, die als spezifische Interaktionspartner dienen. Häufig weist die Struktur dieser Funktionselemente Reihen und Spalten auf. Man spricht dann von sogenannten "Mikroarrays". Da tausende von biologischen bzw. biochemischen Funktionselementen auf einem Chip angeordnet sein können, werden diese in der Regel mit mikrotechnischen Methoden angefertigt.

Als biologische und biochemische Funktionselemente kommen insbesondere DNA, RNA, PNA, (bei Nukleinsäuren und ihren chemischen Derivaten können z.B. Einzelstränge wie Oligonukleotide, Triplex-Strukturen oder Kombinationen hiervon vorliegen), Saccharide, Peptide, Proteine (z.B. Antikörper, Antigene, Rezeptoren), Derivate der kombinatorischen Chemie (z.B. organische Moleküle), Zellbestandteile (z.B. Organellen), einzelne Zellen, mehrzellige Organismen sowie Zellverbände in Frage.

Die am weitesten verbreitete Variante von Biochips sind die Mikroarrays. Dies sind üblicherweise kleine Plättchen ("Chips") aus beispielsweise Glas, Gold, Kunststoff oder Silizium. Zum Nachweis entsprechender biologischer oder biochemischer (Bindungs)Reaktionen werden dabei beispielsweise kleine Mengen an solubilisierten, gleichen oder unterschiedlichen Fängermolekülen, z.B. eine bekannte Nukleinsäuresequenz, in Form von kleinsten Tröpfchen punktförmig und matrizenartig, sogenannte Dots, auf der Oberfläche des BioChip-Grundmoduls fixiert. In der Praxis werden einige hundert bis einige tausend Tröpfchen pro Chip verwendet. Anschließend wird ein zu untersuchender Analyt, der beispielsweise fluoreszenzmarkierte Zielmoleküle enthalten kann, über diese Oberfläche gepumpt. Dabei kommt es im allgemeinen zu unterschiedlichen chemischen (Bindungs)Reaktionen zwischen den im Analyt enthaltenen Zielmolekülen und den fixierten bzw. immobilisierten Fängermolekülen.

Zur Detektion solcher chemischer (Bindungs)Reaktionen zwischen den im Analyt enthaltenen Zielmolekülen und den fixierten bzw. immobilisierten Fängermolekülen werden derzeit verschiedene Verfahren eingesetzt. Zum einen gibt es Bestrebungen, als elektrisches Verfahren für elektronisch auslesbare Biosensoren die Impedanzspektroskopie einzusetzen. Als weitere Möglichkeit zum elektrischen Auslesen wurden entsprechende Redoxverfahren vorgeschlagen, welche bereits näher vor einer möglichen Anwendung stehen. Hierzu werden die nachzuweisenden Zielmoleküle, z.B. DNA-Stränge, mit bestimmten Molekülen markiert. Die im Falle eines Bindungsereignisses hervorgerufene Reduktion bzw. Oxidation kann dann als elektrischer Strom gemessen werden.

In der Mehrheit werden jedoch optische Verfahren eingesetzt. Dazu werden die Zielmoleküle mit Farbstoffmolekülbausteinen, üblicherweise Fluorochromen markiert. Das Vorhandensein und die Intensität von Licht, das von den Fluorochromen emittiert wird, gibt Aufschluß über den Verlauf der Reaktion oder Bindung in den einzelnen Tröpfchen auf dem Substrat, so daß Rückschlüsse auf das Vorhandensein und/oder die Eigenschaft der Zielmoleküle und/oder Fängermoleküle gezogen werden können. Wenn sich die entsprechenden fluoreszenzmarkierten Zielmoleküle des Analyten mit bzw. an den an der Oberfläche des Trägersubstrats immobilisierten Fängermolekülen umsetzen bzw. binden, kann durch optische Anregung mit Licht, z.B. durch eine Laseranregung, und Messung des entsprechenden Fluoreszenzsignals diese Reaktion bzw. Bindung nachgewiesen werden, beispielsweise extern in einem Spektrometer oder einem Fluoreszenzscanner. In ähnlicher Weise kann eine Markierung der Zielmoleküle über Chemolumineszenzmarker erfolgen, so daß der Nachweis über eine Detektion der Chemolumineszenz möglich ist.

In einer Variante solcher Analyseverfahren werden die Moleküle nicht an der planaren Oberfläche eines Sensors bzw. Chips immobilisiert, sondern in einer Porenstruktur. Dies wirkt sich insbesondere auf die Fluidik günstig aus, da ein Durchfluß der zu untersuchenden Substanz möglich wird, wohingegen bei herkömmlichen planaren Sensoren der Materialtransport an der Oberfläche in der Regel diffusiv erfolgt. Zudem können auf der stark vergrößerten Oberfläche mehr Nachweisreaktionen stattfinden. Dadurch steigt die Nachweisempfindlichkeit für biologische Assays. Durch Pumpen der im Analyten gelösten Zielmoleküle durch die Poren bzw. Kanäle zwischen Vorder- und Rückseite des porösen Substrates werden diese in nahen räumlichen Kontakt mit der Porenbegrenzungsfläche (Innenfläche der Poren) des Substrates gebracht (< 10 µm). Auf dieser Größenskala ist die Diffusion ein sehr effektiver Transportprozeß, der innerhalb kurzer Zeit die Distanzen zwischen nachzuweisendem Zielmolekül und dem auf der Oberfläche immobilisierten Fängermolekül überbrückt. Die Geschwindigkeit der Bindungsreaktion kann dadurch erhöht und damit die Dauer des Nachweisverfahrens deutlich verkürzt werden. Ein Beispiel für ein Substrat mit derartiger definierter Porösität ist elektrochemisch hergestelltes poröses Silizium (vgl. DE 42 02 454, EP 0 553 465 oder DE 198 20 756).

Dennoch erfordern auch solche Verfahren mit Hilfe derartiger poröser Substrate bzw. BioChips aufwendige externe Auslesesysteme, wie beispielsweise Spektrometer oder Fluoreszenzscanner.

Der vorliegenden Erfindung liegt somit die Aufgabe zugrunde, eine Vorrichtung bzw. ein "BioChip-Grundmodul" zum Nachweis biochemischer Reaktionen und/oder Bindungen bereitzustellen, die bzw. das im Rahmen der vorgenannten Analyseverfahren keine aufwendigen externen Auslesesysteme erfordert, aber dennoch eine hohe Nachweisempfindlichkeit von mit dem fertigen Biochip durchzuführenden Tests liefert. Schließlich ist es eine Aufgabe der Erfindung, ein Herstellungsverfahren für eine derartige Vorrichtung anzugeben.

Diese Aufgaben werden entsprechend durch eine Vorrichtung gemäß Anspruch 1 sowie durch ein Herstellungsverfahren gemäß Anspruch 15 gelöst. Bevorzugte Ausführungsformen sind Gegenstand der abhängigen Ansprüche.

Gemäß der Erfindung umfaßt eine Vorrichtung ein flächig ausgebildetes Trägermaterial, welches über zumindest einen Oberflächenbereich verteilt eine Vielzahl von Poren aufweist, welche sich von einer Oberfläche des Trägermaterials zu der gegenüberliegenden Oberfläche durchgängig erstrecken, wobei
- die Poren jeweils durch eine Porenbegrenzungsfläche der in dem Trägermaterial ausgebildeten Porenwände begrenzt sind,
- zumindest ein Teil der Porenwände mindestens bereichsweise einen Schichtaufbau mit einem ersten dotierten Halbleiterbereich und einem von der Porenbegrenzungsfläche beabstandeten zweiten, komplementär bzw. entgegengesetzt dotierten Halbleiterbereich unter Bildung eines p-n- oder eines p-i-n-Übergangs aufweist, und
- der erste und der zweite Halbleiterbereich jeweils getrennt voneinander mit einem Anschlußkontakt zur Verschaltung des p-n- bzw. des p-i-n-Übergangs als Photodiode versehen sind.

Erfindungsgemäß werden die Poren des eingesetzten Trägermaterials derart gestaltet, daß in den Porenwänden jeder Pore eine Photodiode ausgebildet ist, welche zur Detektion des entsprechenden Chemolumineszenzsignals bei Reaktion bzw. Bindung eines entsprechend markierten Zielmoleküls in einem Analyten mit entsprechenden Sonden bzw. Fängermolekülen an dem fertigen Biosensor befähigt ist. Die Photodiode wird dabei im wesentlichen durch einen p-n-Übergang innerhalb der Porenwände, d.h. einem p-n-Übergang mit getrennt ankontaktierbaren p- und n- dotierten Halbleiterbereichen innerhalb des mit Poren strukturierten Trägermaterials erzeugt. Beispielsweise ist der erste Halbleiterbereich ein p-dotierter Halbleiterbereich. In diesem Fall weist der zweite Halbleiterbereich eine komplementäre n-Dotierung auf. Wenn umgekehrt der erste Halbleiterbereich p-dotiert ist, weist der zweite Halbleiterbereich eine n-Dotierung auf. Der zweite Halbleiterbereich ist weiter von der Porenbegrenzungsfläche als der erste Halbleiterbereich entfernt.

Betriebsmäßig wird an den p-n-Übergang eine deratige Rückwärtsspannung angelegt, daß in der Verarmungszone des p-n-Übergangs photogenerierte Elektron-Lochpaare feldionisiert werden und als Photostrom extern nachweisbar sind. Wünschenswert ist angsichts der geringen absoluten Chemolumineszenzintensität eine möglichst hohe Nachweisempfindlichkeit der Photodiode. Um eine hohe Quanteneffizienz der Photodiode zu erhalten, wird der p-n-Übergang daher vorzugsweise derart ausgelegt, daß eine vergleichsweise ausgedehnte Verarmungszone erzeugbar ist, welche einen großen Anteil der zu detektierenden Photonen absorbiert. In der einfachsten Auführungsform der erfindungsgemäßen Vorrichtung grenzt der erste dotierte Halbleiterbereich unmittelbar an den zweiten komplementär dotierten Halbleiterbereich an, so daß sich ein p-n- Übergang ergibt. Um die Quantenausbeute der Photodiode weiter zu steigern kann es jedoch vorteilhaft sein, zwischen den n- und den p-dotierten Halbleiterbereichen der Photodiode einen undotierten (intrinsischen) Halbleiterbereich anzuordnen, so daß ein p-i-n-Übergang als Photodiode vorliegt. Die Dicke der intrinsichen Halbleiterschicht kann zur Optimierung der Quanteneffizienz maßgeschneidert werden und beträgt vorzugsweise etwa 100 bis 500 nm.

Vorzugweise beseht der erste Halbleiterbereich und ein eventuell vorhandener intrinsicher Halbleiterbereich zwischen dem ersten und dem zweiten Halbleiterbereich aus einer einoder polykristallinen Halbleiterschicht, welche auf die zweite Halbleiterschicht aufgebracht wird. Besonders bevorzugt ist hierbei eine Polysiliziumschicht, deren Dotierprofil während der Abscheidung gesteuert werden kann.

In dem makroporösen, flächig ausgebildeten Trägermaterial ist über mindestens einen Oberflächenbereich verteilt eine Vielzahl von üblicherweise periodisch angeordneten Poren, welche sich von einer Oberfläche zur gegenüberliegenden Oberfläche des Trägermaterials erstrecken, angeordnet. Im Rahmen der vorliegenden Erfindung können auf dem flächig ausgebildeten makroporösen Trägermaterial bereichsweise auch Sacklöcher, d.h. nur nach einer der Oberflächenseiten geöffnete Poren, vorgesehen werden. Das eingesetzte makroporöse Trägermaterial weist vorzugsweise einen Porendurchmesser von 500 nm bis 100 µm, mehr bevorzugt 2 bis 10 µm auf. Die Dicke des makroporösen Trägermaterials beträgt üblicherweise 100 bis 5.000 µm, vorzugsweise 300 bis 600 µm. Der Abstand von Porenmitte zu Porenmitte (Pitch), d.h. zweier zueinander benachbarter bzw. angrenzender Poren beträgt üblicherweise 1 bis 500 µm, vorzugsweise 3 bis 100 µm. Die Porendichte liegt üblicherweise im Bereich von 10⁴ bis 10⁸/cm². Die Poren in der erfindungsgemäßen Vorrichtung können beispielsweise im wesentlichen rund, ellipsenförmig oder im wesentlichen quadratisch gestaltet sein.

Das makroporöse Substrat bzw. Trägermaterial beseht vorzugsweise aus makroporösem Silizium. Das Silizium kann dabei dotiert, vorzugsweise n-dotiert, oder undotiert sein. Deratiges makroporöses Silizium kann beispielsweise nach dem in EP-A1-0 296 348 beschriebenen Verfahren hergestellt werden.

Der erste dotierte Halbleiterbereich ist vorzugsweise aus p-dotiertem, beispielsweise mit Bor dotiertem, Polysilizium mit einer Dicke im Bereich von 100 bis 200 nm aufgebaut. Die Dotierstoffkonzentration liegt dabei vorzugsweise in einem Bereich von 10¹⁶ bis 10¹⁷ cm⁻³. Der zweite komplementär dotierte Halbleiterbereich ist vorzugsweise aus n-dotiertem, insbesondere p-dotiertem, Silizium mit einer Dicke im Bereich von 100 bis 200 nm aufgebaut, welches vorzugsweise einkristallin ist. Die Dotierstoffkonzentration liegt dabei üblicherweise in einem Bereich von 10¹⁶ bis 10¹⁷ cm⁻³. Die Dotierung wird hierbei derart gewählt, daß sich eine möglichst breite Raumladungszone (RLZ) ausbildet, welche zu einer hohen Absorption der Chemolumineszenzstrahlung und damit zu einer hohen Quantenausbeute führt.

Die Porenwand umfaßt vorzugsweise eine Isolatorschicht, vorzugsweise eine SiO₂-Schicht, deren Innenfläche die Porenbegrenzungsfläche ist. Wie im Folgenden detailliert beschrieben, können an eine derartige Porenbegrenzungsfläche beispielsweise über Linkermoleküle gebundene Fängermoleküle angeordnet sein. Vorzugweise weist die SiO₂-Schicht eine Schichtdicke im Bereich von 10 bis 200 nm auf.

Vorzugsweise weist der Schichtaufbau von einer der Porenwände in einer senkrecht zu der Porenlängsachse verlaufenden Schnittebene folgende Schichtabfolge auf: Pore /Isolatorschicht / erster dotierter Halbleiterbereich /zweiter komplementär dotierter Halbleiterbereich /Halbleitersubstrat. Besonders bevorzugt ist folgende Schichtabfolge: Pore / SiO₂ / p-dotiertes Polysilizium /einkristallines n-dotiertes Silizium / Siliziumsubstrat. Wie zuvor beschrieben kann zwischen dem ersten und dem zweiten Halbleiterbereich ein intrinsischer Halbleiterbereich vorgesehen sein, insbesondere eine undotierte Polysiliziumschicht.

Vorzugsweise ist ausgehend von der Oberfläche des Trägermaterials in dessen Normalenrichtung zumindest bereichsweise ein Schichtaufbau umfassend den ersten und den zweiten Halbleiterbreich vorgesehen, zwischen welchen eine Dielektrikumschicht, vorzugsweise SiO₂, angeordnet ist. Der erste und der zweite Halbleiterbereich, welche den p-n-Übergang in der Porenwand bilden, sind demgemäß als (weiterer) Schichtaufbau parallel zu der Oberfläche des flächigen Trägermaterials aus dem Bereich der Porenwände herausgeführt. Die Schichten dieses Schichtaufbaus verlaufen parallel zu der Substratebene, d.h. im wesentlichen senkrecht zu den Porenlängsachsen. Im Bereich dieses parallel zu der Substratebene verlaufenden Schichtaufbaus ist zwischen dem ersten und dem zweiten Halbleiterbereich eine Dielektrikumschicht angeorndnet, welche die getrennte Kontaktierung der Halbleiterschichten vereinfacht. Somit weisen der erste und der zweite Halbleiterbereich in einer Schnittebene senkrecht zu den Porenlängsachsen im Bereich der Porenöffnungen einen gekrümmten Verlauf mit einem Krümmungswinkel von etwa 90° auf. Um die Anschlußkontäktbildung des ersten und des zweiten Halbleiterbereichs zu verbessern, kann eine lokale n⁺ bzw. p⁺ Ionenimplantation der Halbleiterbereiche zur Erhöhung der Dotierstoffkonzentration vorgesehen sein. Bevorzugt beträgt die Dotierstoffkonzentration des ersten und des zweiten Halbleiterbereichs zumindest 10²⁰ cm⁻³.

Vorzugsweise sind Kontaktlöcher in dem Schichtaufbau zur Ausbildung der Anschlußkontakte für den ersten und den zweiten Halbleiterbereich vorgesehen sind. Die Kontakte können beispielsweise auf Wolfram-Basis ausgebildet sein.

Für bestimmte Nachweisverfahen kann der p-n- Übergang als Avalanchephotodiode (APD) ausgebildet sein. Im Betrieb wird an die Avalanchephotodiode eine derartige Rückwärtsspannung angelegt, daß photogenerierte Elektron-Lochpaare nach ihrer Dissoziierung durch Stoßionisation eine Lawinenverstärkung erfahren, wodurch der zu detektierende Photostrom bereits in der Diode verstärkt werden kann.

Bei einem fertigen Biosensor bzw. BioChip gemäß der vorliegenden Erfindung sind unmittelbar an die Porenbegrenzungsfläche (vorzugsweise die Innenfläche der Isolatorschicht)üblicherweise Linkermoleküle gebunden, an welche wiederum Fängermoleküle, ausgewählt aus der Gruppe, bestehend aus DNA, Proteinen und Liganden, gebunden sind. Die Fängermoleküle können beispielsweise Oligonukleotidsonden sein, die über endständige Amino- oder Thiolgruppen an die Linkermoleküle gebunden sind, die wiederum über kovalente und/oder ionische Gruppen an die Porenbegrenzungsfläche gebunden sind.

Ein weiterer Gegenstand der vorliegenden Erfindung betrifft ein Verfahren zur Herstellung einer wie vorstehend beschriebenen erfindungsgemäßen Vorrichtung, umfassend die Schritte:
(a) Bereitstellen eines flächigen Trägermaterials mit einer Vielzahl von Poren, welche sich von einer Oberfläche des Trägermaterials zu der gegenüberliegenden Oberfläche durchgängig erstrecken;
(b) Bilden des zweiten dotierten Halbleiterbereichs zumindest bereichsweise an den Porenwänden und zumindest bereichsweise an der Oberfläche des flächigen Trägermaterials;
(c) Anordnen einer Dielektrikumschicht, vorzugsweise einer SiO₂-Schicht, zumindest bereichsweise an den zweiten dotierten Halbleiterbereich in einem Abschnitt, welcher an die Oberfläche des flächigen Trägermaterials angrenzt;
(d) Anordnen des ersten dotierten Halbleiterbereichs zumindest bereichsweise an die Dielektrikumsschicht und zumindest bereichsweise an den zweiten dotierten Halbleiterbereich im Bereich der Porenwände unter Ausbildung eines p-n- oder eines p-i-n- Übergangs in dem Bereich der Porenwände;
(e) Ausbilden von Kontaktlöchern zum Freilegen des ersten und des zweiten Halbleiterbereichs; und
(f) Anbringen von Anschlußkontakten an den freigelegten ersten und zweiten Halbleiterbereich zur Verschaltung des p-n- bzw. des p-i-n- Übergangs als Photodiode.

Das Trägermaterial umfaßt vorzugsweise makroporöses Silizium. Das Bilden des zweiten dotierten Halbleiterbereichs in Schritt (b) kann beispielsweise durch Aufbringen einer Phosphorsilikatglasschicht zumindest bereichsweise an den Porenwänden und zumindest bereichsweise an der Oberfläche des flächigen Trägermatierials, Ausdiffundieren von Phosphor in einem Hochtemperaturschritt und anschließendem Entfernen der Phosphorsilikatglasschicht erreicht wird. Die Phosphorsilikatglas(PSG)-Schicht kann hierbei auf die gesamte freiliegende Oberfläche des Trägermaterials aufgebracht werden. Durch Ausdiffusion von Phosphor in einem Hochtemperaturschritt wird ein n-dotierter Halbleiterbereich gebildet in dem undotierten oder schwach n-dotierten Halbleitersubstrat gebildet. Die Dotierung in dem n-dotierten Bereich wird beispielsweise auf 10¹⁶ bis 10¹⁷ cm⁻³ eingestellt. Anschließend wird die Schicht aus PSG, z.B. durch entsprechende Ätzverfahren, entfernt.

Wie zuvor beschreiben weist der zweite (und der erste) Halbleiterbereich im Bereich der Porenöffnung bzw. -mündung vorzugsweise einen gekrümmten Abschnitt auf, welcher den parallel zu den Porenlängsachsen verlaufenden Schichtaufbau (p-n-Übergang) im Bereich der Porenwände mit einem senkrecht zu den Porenlängsachsen verlaufenden Schichtaufbau (parallel zu der Flächenebene des flächigen Trägermaterials) verbindet. Um einen möglichst geringen lateralen Schichtwiderstand des ersten und des zweiten Halbleiterbereichs im Bereich des senkrecht zu den Porenlängsachsen verlaufenden Schichtaufbaus zu erzielen, können die Halbleiterbereich in diesem Bereich durch Ionenimplantation eine höhere Dotierstoffkonzentration aufweisen.

Der Schritt (d) des Anordnens des ersten dotierten Halbleiterbereichs (20) umfaßt vorzugsweise die Abscheidung einer dotierten Polysiliziumschicht. Die beispielsweise mit Bor dotierte Polysiliziumschicht kann über die gesamte freiliegende Oberfläche des flächigen Trägermaterials aufgebracht werden. Die Polysiliziumschicht kann nachfolgend über eine Lochmaske, beispielsweise auf Basis eines photolithographisch strukturierten Photolacks, zur Öffnung der Kontaktlöcher strukturiert werden. Zur Strukturierung der Lochmaske kann vorzugsweise auch fokussierte Ionenstrahllithographie zum Einsatz kommen.

Vorzugsweise wird nach dem Schritt (d) des Anordnens des ersten dotierten Halbleiterbereichs eine Isolatorschicht, vorzugsweise eine SiO₂-Schicht, an den ersten Halbleiterbereich angeordnet, deren Innenfläche die Porenbegrenzungsfläche ist. Der Schritt des Anordnens der Isolatorschicht kann vorzugsweise mittels CVD-Abscheidung durchgeführt werden. An diese Isolatorschicht kann in einem späteren Prozeßschritt das Anbringen bzw. Binden von Linkerund Fängermolekülen erfolgen.

Solche Linkermoleküle unterliegen keiner spezifischen Beschränkung, solange sie befähigt sind, an die auf der Oberfläche der Isolatorschicht, z.B. einer SiO₂-Schicht, vorliegenden OH-Gruppen kovalent zu binden und weiter eine funktionelle Gruppe aufweisen, die zur kovalenten Bindung mit als Sonden in biologisch-chemischen Reaktionen einsetzbaren Fängermolekülen befähigt ist. Solche Linkermoleküle sind üblicherweise auf der Basis einer Silizium-organischen Verbindung. Derartige bifunktionelle Silizium-organische Verbindungen können beispielsweise Alkoxysilan-Verbindungen mit einer oder mehreren terminalen funktionalen Gruppen, ausgewählt aus Epoxy, Glycidyl, Chlor, Mercapto oder Amino, sein. Vorzugsweise ist die Alkoxysilan-Verbindung ein Glycidoxyalkylalkoxysilan, wie z.B. 3-Glycidoxypropyltrimethoxysilan, ein Mercaptoalkylalkoxysilan, wie z.B. γ-Mercaptopropyltrimethoxysilan, oder ein Aminoalkylalkoxysilan, wie z.B. N-β-(aminoethyl) γ-aminopropyltrimethoxysilan. Die Länge der als Spacer zwischen der funktionellen Gruppe, wie z.B. Epoxy bzw. Glycidoxy, welche mit dem Fängermolekül bzw. der Sonde bindet, und der Trialkoxysilangruppe wirkenden Alkylenreste unterliegt dabei keiner Beschränkung. Derartige Spacer können auch Polyethylenglykolreste sein.

Zur Endfertigung eines erfindungsgemäßen optoelektronischen BioChips bzw. Biosensors kann dann das Anbinden bzw. Koppeln von Fängermolekülen, wie beispielsweise Oligonukleotiden bzw. DNA-Molekülen, an das Trägermaterial über die Linkermoleküle nach den im Stand der Technik üblichen Verfahren erfolgen, beispielsweise mittels Behandeln des porösen Trägermaterials bei Verwendung von Epoxysilanen als Linkermoleküle durch anschließende Reaktion der terminalen Epoxidgruppen mit terminalen primären Aminogruppen oder Thiolgruppen von Oligonukleotiden bzw. DNA-Molekülen, die in entsprechenden Analyseverfahren als immobilisierte bzw. fixierte Fängermoleküle für die im zu untersuchenden Analyten vorliegenden Zielmoleküle fungieren. Dabei können beispielsweise die als Fängermoleküle verwendbaren Oligonukleotide unter Verwendung der Synthesestrategie, wie in Tet. Let. 22, 1981, Seiten 1859 bis 1862, beschrieben, hergestellt werden. Die Oligonukleotide können dabei während des Herstellungsverfahrens entweder an der 5- oder der 3-Endstellung mit terminalen Aminogruppen derivatisiert werden. Eine weitere Möglichkeit der Anbindung solcher Fängermoleküle an die Innenwandoberflächen der Poren kann durchgeführt werden, indem das Substrat zunächst mit einer Chlorquelle, wie Cl₂, SOCl₂, COCl₂ oder (COCl)₂, gegebenfalls unter Verwendung eines Radikalinitiators wie Peroxide, Azoverbindungen oder Bu₃SnH, behandelt wird und anschließend mit einer entsprechenden nucleophilen Verbindung, wie insbesondere mit Oligonukleotiden bzw. DNA-Molekülen, die terminale primäre Aminogruppen oder Thiolgruppen aufweisen, umgesetzt werden (siehe WO 00/33976).

Werden die in einem Analyten zu bestimmenden bzw. untersuchenden Zielmoleküle mit Chemolumineszenzfarbstoffen markiert, so erfordert ein entsprechendes Analyseverfahren unter Verwendung eines optoelektronischen Biosensors gemäß der vorliegenden Erfindung keine externe Detektionsausstattung, wie einen Spektrometer oder Fluoreszenzscanner, so daß eine komplette Integration auf einem Chip möglich ist. Das Auslesen der (Bindungs)Reaktionsereignisse zwischen den im Analyt enthaltenen Zielmolekülen und den fixierten bzw. immobilisierten Fängermolekülen erfolgt über die Messung des in der Photodiode erzeugten Photostroms, wobei an die Photodiode eine Rückwärtsspannung angelegt wird. Wie zuvor beschrieben kann gegebenenfalls eine Lawinenverstärkung zur Signalverstärkung eingesetzt werden. Selbstverständlich können im Rahmen der vorliegenden Erfindung auch die Fängermoleküle anstelle der Zielmolekûle mit Chemolumineszenzmarkern versehen werden.

Gemäß einem weiteren Aspekt der Erfindung wird ein Verfahren zum Nachweis von biochemischen Reaktionen und/oder Bindungen unter Verwendung einer oben beschriebenen erfindungsgemäßen Vorrichtung vorgeschlagen, wobei die biochemischen Reaktionen und/oder Bindungen über den Photostrom der Photodiode nachgewiesen werden, welcher durch eine Lichtemission von Chemolumineszenzmarkern von Fänger- und/oder Zielmolekülen hervorgerufen wird.

Die Erfindung wird nachfolgend unter Bezugnahme auf begleitende Bezeichnungen bevorzugter Ausführungsformen beispielhaft beschrieben. Es zeigt:
- Fig. 1 (a) bis (g): schematische Querschnittansichten von Zwischenprodukten einer bevorzugten Ausführungsform einer erfindungsgemäßen Vorrichtung während des Herstellungsprozesses;
- Fig. 2: schematische Querschnittsansicht eines Teilbereichs des Zwischenproduktes gemäß Fig. 1 (g) ;
- Fig. 3: schematische Aufsicht auf eine weitere bevorzugte Ausführungsform der erfindungsgemäßen Vorrichtung nach abgeschlossenem Prozeßablauf; und
- Fig. 4 (a) bis (c): schematische Schnittansichten einer Pore einer.bevorzugten Ausführungsform einer erfindungsgemäßen Vorrichtung während eines Chemolumineszenz-Detektionsverfahrens.

Fig. 1 (a) bis (g) zeigt schematische Schnittansichten von Zwischenprodukten während der Herstellung einer bevorzugten Ausführungsform einer erfindungsgemäßen Vorrichtung. Die Schnittebene verläuft parallel zur Normalenrichtung eines makroporösen Trägermaterials 10 und schneidet Poren 11. Vorzugsweise ist das makroporöse Trägermaterial 10 ein einkristalliner Siliziumwafer, welcher beispielsweise n-dotiert ist. Durch das eingangs genannte elektrochemische Porenätzen von Silizium sind im wesentlichen in Normalenrichtung des Trägermaterials 10 Poren 11 in dem Trägermaterial 10 ausgebildet, welche von einer Oberfläche 12 zu der gegenüberliegenden Oberfläche 13 des Trägermaterials 10 durchgängig verlaufen. Die Porenlänge entspricht vorzugsweise typischen Waferdicken und liegt somit im Bereich von 300 µm bis 500 µm, typischerweise 470 µm. Der Porendurchmesser kann durch das elektrochemische Porenätzverfahren gezielt eingestellt werden und beträgt typischerweise etwa 10 µm (vgl. **Fig. 1(a)**).

Um einen seriellen Anschlußwiderstand des später auszubildenden p-n- bzw. p-i-n-Übergangs möglichst kein zu halten sowie die Anschlusskontaktbildung zu vereinfachen, erfolgt zunächst eine Implantation der oberflächennahen Schicht des Siliziumwafers 10 nahe seiner Oberfläche 12 zur Ausbildung einer n⁺-Dotierung. Die Dotierstoffkonzentration kann hierbei sehr hoch gewählt werden, beispielsweise im Bereich von größer als 10²⁰ cm⁻³.

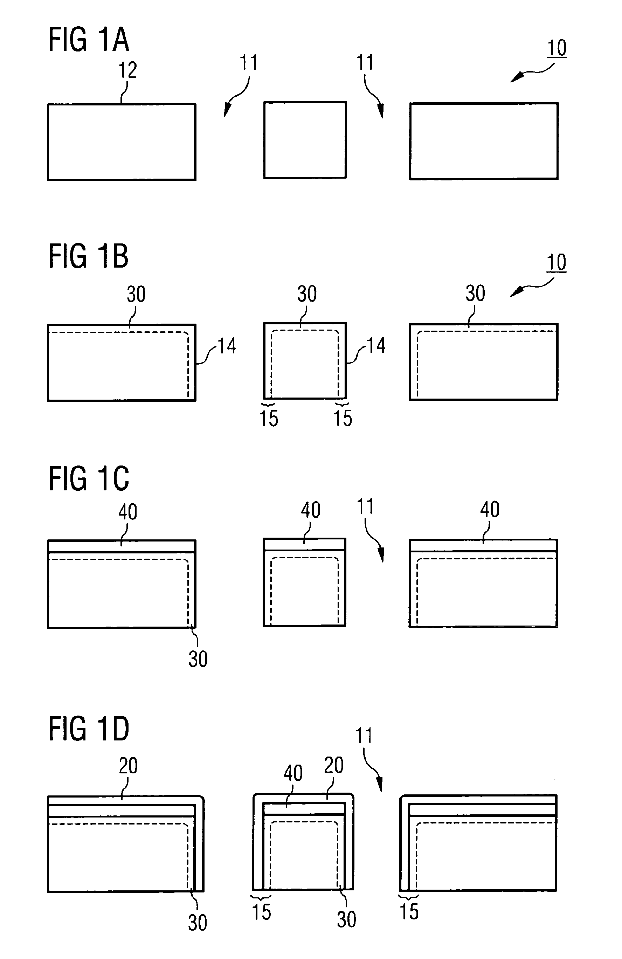

Um das Dotierprofil desjenigen Bereichs des Trägermaterials 10 exakt steuern zu können, welcher an die Innenflächen der Poren 11 angrenzt, wird ein zusätzlicher Diffusionsschritt zum Einbringen von Dotieratomen in den Halbleitereinkristall verwendet. Vorzugsweise wird auf die gesamte freiliegende Oberfläche des Trägermaterials 10 beispielsweise eine (nicht dargestellte) Phosphorsilikatglasschicht (PSG) aufgebracht und nachfolgend einem Hochtemperaturdiffusionsschritt unterworfen. Die Phosphorsilikatglasschicht bedeckt auch die Innenflächen der Poren 11. Während des Hochtemperaturschritts diffundiert Phosphor von der PSG-Schicht in den oberflächennahen Bereich des Trägermaterials 10, so daß dieser n-dotiert wird. Hierdurch wird in den Porenwänden 15 ein n-dotierter Halbleiterbereich 30 ausgebildet, welcher als zweiter Halbleiterbereich bezeichnet wird. Die Dotierstoffkonzentration des zweiten Halbleiterbereichs 30 liegt vorzugsweise zwischen 10¹⁶ bis 10¹⁷ cm⁻³ und weist eine Tiefenausdehnung von typischerweise 100 bis 200 nm auf. Es sollte verstanden werden, daß der zweite Halbleiterbereich 30 auch p-dotiert sein kann. In diesem Fall kommt vorzugsweise ein p-dotierter Halbleiterwafer zum Einsatz.Im Anschluß an den Hochtemperaturschritt wird die PSG-Schicht durch einen Ätzschritt entfernt. Die Vorrichtung in diesem Verfahrensstadium ist in **Fig. 1(b)** dargestellt.

Nachfolgend wird auf die Oberfläche 12 des Trägermaterials 10 eine Dielektrikumsschicht 50, vorzugsweise eine Oxidschicht (SiO₂-Schicht), aufgebracht. Hierzu wird zunächst mittels eines CVD-Prozesses ein Nitrid, vorzugsweise Si₃N₄ abgeschieden und mittels eines CMP-Schritts bis auf die Oberfläche 12 des Halbleiterwafers 10 abgetragen. Hierdurch werden die Poren 11 mit Nitrid gefüllt, so daß sich eine ebene Oberfläche ergibt. Die freiliegende Oberfläche 12 des Halbleiterwafers 10 wird nachfolgend oxidiert, um die Dielektrikumsschicht 40 auszubilden. Das noch in den Poren 11 vorliegende Nitrid wird im Anschluß durch einen naßchemischen Ätzschritt, welcher selektiv zu der Dielektrikumsschicht 40 (Oxidschicht) ist, entfernt (vgl. **Fig. 1(c)**).

Wie in **Fig. 1(d)** schematisch dargestellt ist, erfolgt nachfolgend ein Abscheideschritt einer Halbleiterschicht, vorzugsweise einer p-dotierten Polysiliziumschicht, welche den sogenannten ersten Halbleiterbereich 20 bildet. Bei der in Fig. 1(d) dargestellten bevorzugten Ausführungsform grenzt die p-dotierte Polysiliziumschicht 20 einerseits an die Oberfläche der Dielektrikumsschicht 40 und andererseits an die Innenflächen der Poren 11, die sogenannten Porenbegrenzungsflächen 14, an. Der an die Dielektrikumsschicht 40 angrenzende Teil des ersten Halbleiterbereichs 20 geht ohne Unterbrechung in den an die Porenbegrenzungsfläche 14 angrenzenden Teil über. Somit kann durch einen omischen Kontakt an denjenigen Teilbereich des ersten Halbleiterbereichs 20, welcher parallel zur Flächenebene des Halbleiterwafers 10 verläuft, der an die Porenbegrenzungsflächen 14 angrenzende andere Teilbereich des ersten Halbleiterbereich 20 elektrisch kontaktiert werden.

Durch das Abscheiden des p-dotierten Polysiliziums an die Porenbegrenzungsfläche 14 wird ein p-n-Übergang in den Porenwänden 15 ausgebildet, welcher derart ausgebildet ist, daß er sich als Photodiode eignet. Im vorliegenden bevorzugten Fall wird der n-dotierte Bereich durch den zweiten Halbleiterbereich 30 und der p-dotierte Bereich durch den ersten Halbleiterbereich 20 gebildet. Das abgeschiedene Polysilizium wird *in situ* dotiert, indem beispielsweise beim Abscheiden in üblicher Weise Bor eingebracht wird. Indem während des Abscheidevorgangs des Polysiliziums erst nach einer gewissen Abscheidedauer die Bor-Dotierquelle geöffnet wird, kann eine nominell undotierte, intrinsische Halbleiterschicht aufgebracht werden. In diesem Fall läßt sich ein p-i-n-Übergang ausbilden, bei welchem die dotierten Halbleiterbereiche durch einen intrinsischen Halbleiterbereich getrennt werden. Derartige p-i-n-Übergänge können vorteilhaft sein, wenn es eine besonders hohe Quanteneffizienz der Photodiode zu erreichen gilt. Alternativ können auch p-n-Übergänge mit Dotierprofilen eingesetzt werden, welche zur Beschaltung als Lawinenphotodioden (APD) ausgelegt sind. Hierbei werden lichtinduzierte Elektron-Loch-Paare in der Verarmungszone des p-n-Übergangs felddisoziiert und derartig beschleunigt, daß es zu einer Stoßionisation und damit lawinenartigen Verstärkung des Photostroms kommt.

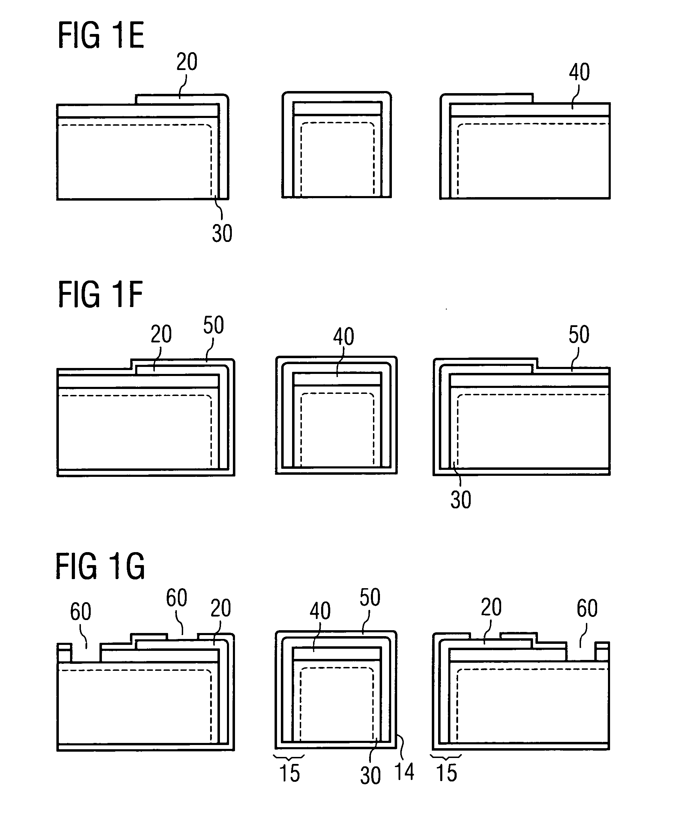

Nachfolgen wird, wie in **Fig. 1(e)** dargestellt, der erste Halbleiterbereich 20 in dem Teilbereich, welcher parallel zu dem flächigen Trägermaterial 10 verläuft, strukturiert. Hierzu kann beispielsweise fokussierte Ionstrahllitographie Verwendung finden. Bei Auswahl von geeigneten Photoresistmaterialien ist jedoch auch eine übliche optische Photolithographie und -strukturierung auf dem makroporösen Trägermaterial 10 möglich. Im Anschluß wird eine Isolatorschicht 50, vorzugsweise eine SiO₂-Schicht, über die gesamte freiliegende Oberfläche des makroporösen Trägermaterials 10 abgeschieden. Die Innenflächen der Isolatorschicht 50 in den Poren 11 stellen die Porenbegrenzungsflächen 14 dar, an welche später - über Linkermoleküle - sogenannte Fängermoleküle für biochemische Nachweisverfahren angeordnet werden können. Das Zwischenprodukt der bevorzugten Ausführungsform der erfindungsgemäßen Vorrichtung in diesem Herstellungsstadium ist in **Fig. 1(f)** dargestellt.

Durch geeignete Lithographie- und Ätzschritte werden nachfolgend Kontaktlöcher 60 zur Ausbildung von (nicht dargestellten) Anschlußkontakten an den ersten Halbleiterbereich 20 und den zweiten Halbleiterbereich 30 ausgebildet. Die Halbleiterbereiche 20, 30 sind somit elektrisch getrennt voneinander kontaktierbar. Falls erforderlich kann vor der Ausbildung der Anschlußkontakte eine optionale lokale Implantation des ersten Halbleiterbereichs 20 in einem derartigen Gebiet erfolgen, in welchem der Anschlußkontakt ausgebildet werden soll (vgl. **Fig. 1(g)**).

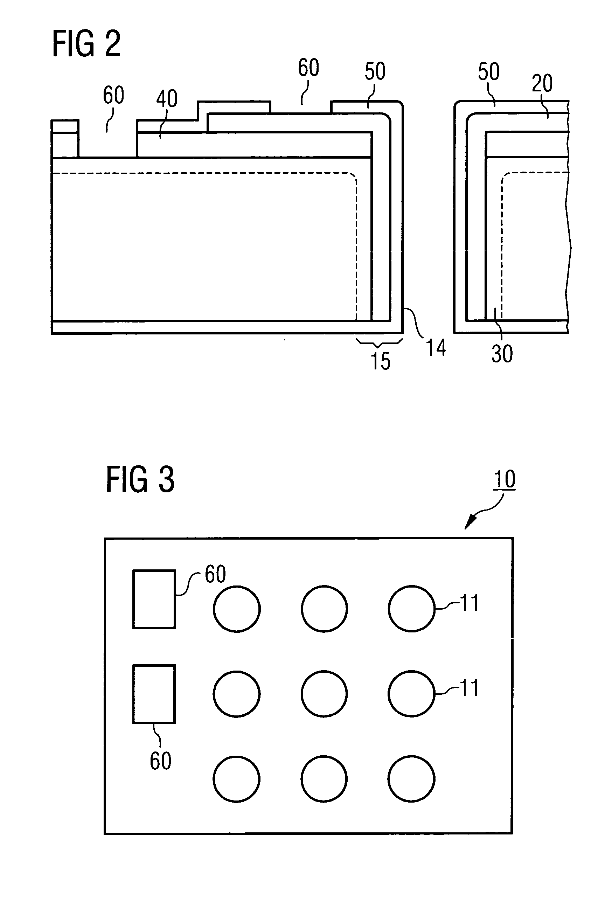

Eine vergrößerte, schematische Querschnittsansicht der Vorrichtung gemäß **Fig. 1(g)** ist in **Fig. 2** dargestellt. In diesem Verfahrensstadium stellt die bevorzugte Ausführungsform der erfindungsgemäßen Vorrichtung ein "Grundmodul" für einen optoelektronischen Biodetektor dar, welcher insbesondere unmittelbar vor einem Einsatz als biochemische Detektionsvorrichtung in oben beschriebener Weise mit geeigneten Linker- und Fängermolekülen entlang der Porenbegrenzungsflächen 14 versehen werden kann.

**Fig. 3** zeigt eine (nicht maßstabsgerechte) schematische Aufsicht auf eine weitere bevorzugte Ausführungsform der erfindungsgemäßen Vorrichtung. Die Poren 11 weisen in dieser Ausführungsform einen runden Querschnitt in einer parallel zu der Flächenebene des flächigen Trägermaterials 10 verlaufenden Schnittebene auf. Anschlußkontaktlöcher 60 sind in einem Randbereich neben dem matrixartig aufgebauten Porenfeld zur Ausbildung der Anschlußkontakte vorgesehen. Im Betrieb wird an die (nicht dargestellten) Anschlußkontakte eine derartige Spannung angelegt, daß der p-n-Übergang bzw. der p-i-n-Übergang in Rückwärtsrichtung als Photodiode gepolt ist. Der aufgrund von Chemolumineszenzereignissen ausgelöste Photostrom wird zur Bestimmung der Lumineszenzintensität detektiert.

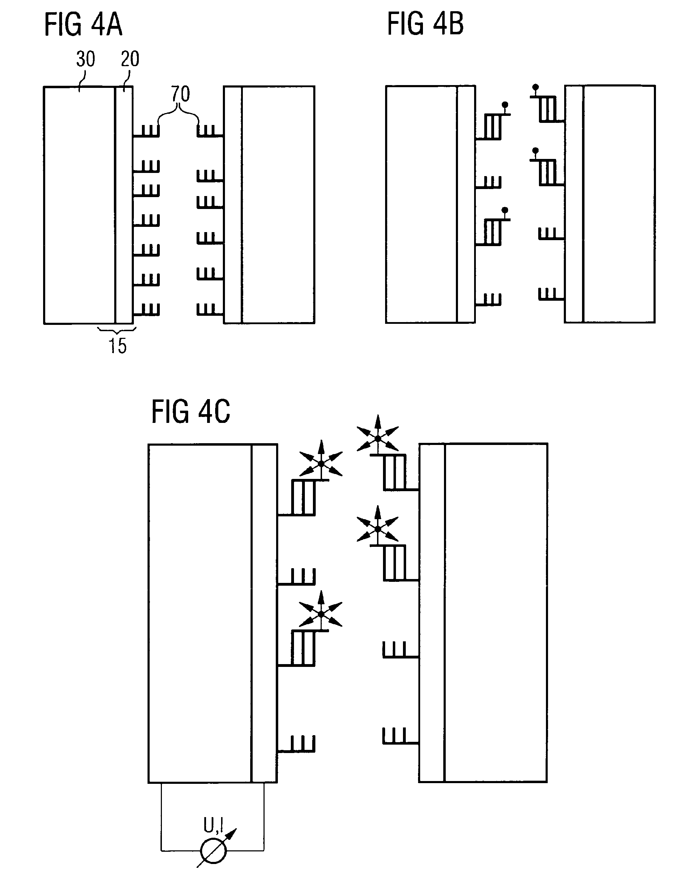

Vor dem Einsatz der erfindungsgemäßen Vorrichtung als optoelektronischer Biosensor werden insbesondere an die Porenbegrenzungsflächen 14 in eingangs beschriebener Weise Fängermoleküle 70 angeordnet, welche auf die nachzuweisende Targetsubstanz abgestimmt sind. Nachfolgend werden beispielsweise mit Chemolumineszenzmarkern versehene Targetmoleküle durch den porenstrukturierten Wafer 10 geleitet, wobei es zu Hybridisierungen an den Fängermolekülen kommt (vgl. **Fig. 4(a)** und **(b)**). Durch die Zugabe einer geeigneten Chemoluminiszenzsubstanz erfolgt eine Lichtemission der Chemoluminiszenzmarker, welche elektrisch mittels des als Photodiode verschalteten p-n-Übergangs bzw. des p-i-n-Übergangs nachgewiesen werden kann. Hierzu wird bei geeigneter Rückwärtsspannung der Photodiode der lichtinduzierte Photostrom gemessen. Bei der Verwendung von Chemolumineszenzmarkern ist in dieser Anordnung weder eine externe Anregungsquelle noch eine externe Detektion nötig, so daß eine komplette Integration des optoelektronischen Biosensors in einem einzigen Chip möglich ist.

### Bezugszeichenliste

- 10: makroporöses Trägermaterial, insb. Si-Halbleiterwafer
- 11: Pore
- 12,13: Oberflächenseiten des Trägermaterials
- 14: Porenbegrenzungsfläche der Porenwand
- 15: Porenwand
- 20: erster (vorzugsweise p-dotierter) Halbleiterbereich
- 30: zweiter (vorzugsweise n-dotierter) Halbleiterbereich
- 40: Dielektrikumschicht
- 50: Isolatorschicht, vorzugsweise Oxidschicht
- 60: Kontaktlöcher für Anschlußkontakte
- 70: Fängermoleküle

## Patentansprüche

1. Vorrichtung mit einem flächig ausgebildetem Trägermaterial (10), welches über zumindest einen Oberflächenbereich verteilt eine Vielzahl von Poren (11) aufweist, welche sich von einer Oberfläche (12) des Trägermaterials (10) zu der gegenüberliegenden Oberfläche (13) durchgängig erstrecken, wobei
- die Poren (11) jeweils durch eine Porenbegrenzungsfläche (14) der in dem Trägermaterial (10) ausgebildeten Porenwände (15) begrenzt sind,
- zumindest ein Teil der Porenwände (15) mindestens bereichsweise einen Schichtaufbau mit einem ersten dotierten Halbleiterbereich (20) und einem von der Porenbegrenzungsfläche (14) beabstandeten zweiten, komplementär dotierten Halbleiterbereich (30) unter Bildung eines p-n- oder eines p-i-n-Übergangs aufweist, und
- der erste (20) und der zweite (30) Halbleiterbereich jeweils getrennt voneinander mit einem Anschlußkontakt zur Verschaltung des p-n- bzw. des p-i-n-Übergangs als Photodiode versehen sind.

2. Vorrichtung nach Anspruch 1, wobei das Trägermaterial (10) makroporöses Silizium ist und eine Dicke zwischen 100 bis 5.000 µm aufweist.

3. Vorrichtung nach Anspruch 1 oder 2, wobei die Porendichte im Bereich von 10⁴ bis 10⁸/cm² liegt.

4. Vorrichtung nach einem der vorhergehenden Ansprüche, wobei der erste Halbleiterbereich (20) aus p-dotiertem, vorzugsweise mit Bor dotiertem, Polysilizium mit einer Dicke im Bereich von 100 bis 200 nm aufgebaut ist, wobei die Dotierstoffkonzentration vorzugsweise im Bereich von 10¹⁶ cm⁻³ bis 10¹⁷ cm⁻³ liegt .

5. Vorrichtung nach einem der vorhergehenden Ansprüche, wobei der zweite Halbleiterbereich (30) aus n-dotiertem, vorzugsweise mit Phosphor dotiertem, Silizium mit einer Dicke im Bereich von 100 bis 200 nm aufgebaut ist, wobei die Dotierstoffkonzentration vorzugsweise im Bereich von 10¹⁶ cm⁻³ bis 10¹⁷ cm⁻³ liegt.

6. Vorrichtung nach einem der Ansprüche 1 bis 5, wobei die Porenwand (15) eine Isolatorschicht (50), vorzugsweise eine SiO₂-Schicht, umfaßt, deren Innenfläche die Porenbegrenzungsfläche (14) ist.

7. Vorrichtung nach Anspruch 6, wobei die Isolatorschicht (50) eine Schichtdicke im Bereich von 10 bis 200 nm aufweist.

8. Vorrichtung nach einem der vorangegangenen Ansprüche, wobei ausgehend von der Oberfläche (12) des Trägermaterials (10) in dessen Normalenrichtung zumindest bereichsweise ein Schichtaufbau umfassend den ersten (20) und den zweiten (30) Halbleiterbreich vorgesehen ist, zwischen welchen eine Dielektrikumschicht (40), vorzugsweise SiO₂, angeordnet ist.

9. Vorrichtung nach Anspruch 8, wobei Kontaktlöcher (60) in dem Schichtaufbau zur Ausbildung der Anschlußkontakte für den ersten (20) und den zweiten (30) Halbleiterbereich vorgesehen sind.

10. Vorrichtung nach einem der vorangegangenen Ansprüche, wobei der p-n- Übergang als Avalanchephotodiode ausgebildet ist.

11. Vorrichtung nach einem der vorhergehenden Ansprüche, wobei an zumindest eine der Porenbegrenzungsflächen (14) von zumindest einer der Poren (11) zumindest bereichsweise kovalent Fängermoleküle (70), ausgewählt aus der Gruppe, bestehend aus DNA, Proteinen und Liganden, gebunden sind.

12. Vorrichtung nach Anspruch 11, wobei die Fängermoleküle (70) Oligonukleotidsonden sind, die über endständige Aminooder Thiolgruppen an Linkermoleküle gebunden sind, die wiederum über kovalente und/oder ionische Gruppen an die Porenbegrenzungsflächen (14) gebunden sind.

13. Vorrichtung nach Anspruch 11 oder 12, wobei die Fängermoleküle mit Chemolumineszenzmarkern markiert sind.

14. Verwendung der Vorrichtung nach einem der vorhergehenden Ansprüche als optoelektronischer Biosensor in Verfahren zum Nachweis biochemischer Reaktionen und/oder Bindungen sowie hierfür insbesondere zur Untersuchung von enzymatischen Reaktionen, Nukleinsäure-Hybridisierungen, Protein-Protein-Wechselwirkungen und Protein-Liganden-Wechselwirkungen.

15. Verfahren zur Herstellung einer Vorrichtung nach einem der Ansprüche 1 bis 13 mit den Schritten:
(a) Bereitstellen eines flächigen Trägermaterials (10) mit einer Vielzahl von Poren (11), welche sich von einer Oberfläche (12) des Trägermaterials (10) zu der gegenüberliegenden Oberfläche (13) durchgängig erstrecken;
(b) Bilden des zweiten dotierten Halbleiterbereichs (30) zumindest bereichsweise an den Porenwänden (15) und zumindest bereichsweise an der Oberfläche (12) des flächigen Trägermaterials (10);
(c) Anordnen einer Dielektrikumschicht (40), vorzugsweise einer SiO₂-Schicht, zumindest bereichsweise an den zweiten dotierten Halbleiterbereich (30) in einem Abschnitt, welcher an die Oberfläche (12) des flächigen Trägermaterials (10) angrenzt;
(d) Anordnen des ersten dotierten Halbleiterbereichs (20) zumindest bereichsweise an die Dielektrikumsschicht (40) und zumindest bereichsweise an den zweiten dotierten Halbleiterbereich (30) im Bereich der Porenwände (15) unter Ausbildung eines p-n- oder eines p-i-n- Übergangs in dem Bereich der Porenwände (15);
(e) Ausbilden von Kontaktlöchern (60) zum Freilegen des ersten (20) und des zweiten (30) Halbleiterbereichs; und
(f) Anbringen von Anschlußkontakten an den freigelegten ersten (20) und zweiten (30) Halbleiterbereich zur Verschaltung des p-n- bzw. des p-i-n- Übergangs als Photodiode.

16. Verfahren nach Anspruch 15, wobei das Trägermaterial (10) aus makroporösem Silizium ist.

17. Verfahren nach Anspruch 15 oder 16, worin das Bilden des zweiten dotierten Halbleiterbereichs (30) in Schritt (b) durch Aufbringen einer Phosphorsilikatglasschicht zumindest bereichsweise an den Porenwänden (15) und zumindest bereichsweise an der Oberfläche (12) des flächigen Trägermatierials (10), Ausdiffundieren von Phosphor in einem Hochtemperaturschritt und anschließendem Entfernen der Phosphorsilikatglasschicht erreicht wird.

18. Verfahren nach einem der vorhergehenden Ansprüche 15 bis 17, wobei nach dem Schritt (d) des Anordnens des ersten dotierten Halbleiterbereichs (20) eine Isolatorschicht (50), vorzugsweise eine SiO₂-Schicht, an den ersten Halbleiterbereich (20) angeordnet wird, deren Innenfläche die Porenbegrenzungsfläche (15) ist.

19. Verfahren nach Anspruch 18, worin der Schritt des Anordnens der Isolatorschicht (50) mittels CVD-Abscheidung durchgeführt wird.

20. Verfahren nach einem der vorhergehenden Ansprüche 15 bis 19, wobei der Schritt (d) des Anordnens des ersten dotierten Halbleiterbereichs (20) die Abscheidung einer dotierten Polysiliziumschicht umfaßt.

21. Verfahren nach einem der vorhergehenden Ansprüche 15 bis 20, weiter umfassend den Schritt des Bindens von Fängermolekülen (70), ausgewählt aus der Gruppe, bestehend aus DNA, Proteinen und Liganden, über kovalente und/oder ionische Gruppen an die Porenbegrenzungsflächen (14).

22. Verfahren nach Anspruch 21, wobei zuerst Linkermoleküle an die Porenbegrenzungsflächen (14) gebunden werden und anschließend Fängermoleküle, insbesondere Oligonukleotidsonden, über endständige Amino- oder Thiolgruppen an die Linkermoleküle gebunden werden.
